Europäisches Patentamt

European Patent Office

Office européen des brevets

(19)

(11) Veröffentlichungsnummer: **0 002 816**
**A1**

(12) # EUROPÄISCHE PATENTANMELDUNG

(21) Anmeldenummer: **78101815.5**

(22) Anmeldetag: **22.12.78**

(51) Int. Cl.²: **H 01 L 31/02, H 01 L 25/04**

(30) Priorität: **22.12.77 DE 2757493**

(43) Veröffentlichungstag der Anmeldung: **11.07.79**
Patentblatt 79/14

(84) Benannte Vertragsstaaten: **BE CH FR GB IT NL SE**

(71) Anmelder: **W. Möbes Nachfl. GmbH & Co. KG, D-8351 Haus im Wald Nr. 117 (DE)**

(72) Erfinder: **Sarfert, Hubertus, Heibimühle, D-8391 Perlesreut (DE)**

(74) Vertreter: **Kuhnen, Rainer Andreas, Dipl.-Ing. et al, Kuhnen & Wacker Patentanwälte Schneggstrasse 3-5 Postfach 1729, D-8050 Freising (DE)**

(54) **Solarzellenanordnung zur Erzeugung elektrischer Energie und aus einer Mehrzahl von Solarzellenanordnungen bestehender Solargenerator sowie Verfahren zu ihrer Herstellung.**

(57) Eine Solarzellenanordnung weist ein Spritzgußteil (4) aus Acryl-Kunststoff auf, das an seiner Außenseite Auswölbungen zur Bildung konvexer Linsen (15) für die einzelnen Solarzellen (1) und an seiner Innenseite nestartige Vertiefungen (5) zur Aufnahme je einer Solarzelle aufweist. Die nestartigen Vertiefungen (5) werden mit Polyester-Kunststoff vergossen und in diesen werden die elektrisch leitend miteinander verbundenen Solarzellen (1) eingedrückt und so ohne eine Gefahr von Lufteinschlüssen an der Zellenvorderseite in ihrer Lage definiert und gesichert. Eine solche Solarzellenanordnung mit wabenförmig auf engstem Raum angeordneten Solarzellen (1) kann als Deckel für einen Kasten zur Aufnahme von Speicher- und Regelaggregaten für den erzeugten Strom, beispielsweise in Form eines Weidezaungerätes, verwendet werden. Durch Nebeneinanderanordnung derartiger Solarzellenanordnungen auf einer gemeinsamen Konsole (17) wird ein Solargenerator gebildet, wobei die einzelnen Solarzellenanordnungen in die freie Oberfläche der Konsole aus Kunststoff vor der Aushärtung eingedrückt werden und Kontaktfahnen (8) an der Unterseite der Konsole (17) herausragen.

# PATENTANWÄLTE 0002816

Telefon 0 81 61 / 6 20 91
Telex: 526 547 pawa d
Telegr. PAWAMUC-FREISING

RAINER-ANDREAS
**KUHNEN & WACKER**
DIPL.-ING.

PAUL-ALEXANDER

DIPL.-ING. u. DIPL.-WIRTSCH.-ING.

Schneggstr. 3–5, Postfach 1729
D-8050 FREISING / MÜNCHEN

W. Möbes Nachfl. GmbH & Co. KG      55 MO 0509 2/ko
8351 Haus i.W. Nr. 117

---

Solarzellenanordnung zur Erzeugung elektrischer Energie und
aus einer Mehrzahl von Solarzellenanordnungen bestehender Solargenerator sowie Verfahren zu ihrer Herstellung

---

Die Erfindung betrifft eine Solarzellenanordnung nach dem
Oberbegriff des Anspruchs 1 sowie einen aus einer Mehrzahl
von Solarzellenanordnungen bestehenden Solargenerator und
zu ihrer Herstellung besonders geeignete Verfahren.

Ein solcher Solarzellengenerator ist aus der DT-OS 24 45 642
bekannt. Dieser bekannte Solarzellengenerator wird dadurch
hergestellt, daß die Solarzellen mit ihren lichtempfindlichen Seiten auf einer planen Scheibe aus einem für Sonnenstrahlen weitgehend durchlässigen Kunststoff auf der Basis
von Acrylsäureester gelegt und rückseitig mit flüssigem
oder körnigem Kunststoff desselben Aufbaus aufgefüllt und
so ebenfalls allseitig in einem einheitlichen Werkstoff
eingebettet werden.

Ein solcher Solarzellengenerator weist verschiedene Nachteile auf. Da die einzelnen Solarzellen an der Rückseite
der Scheibe nicht lagegesichert sind, erfordert das Auflegen der einzelnen Solarzellen große Sorgfalt, damit keine
zumindest das einwandfreie Aussehen des Solarzellengenerators
beeinträchtigenden gegenseitige Verschiebungen der einzelnen Solarzellen auftreten. Auch beim nachfolgenden Vergießen der auf der Rückseite der Scheibe liegenden Solarzellen sind störende Verschiebungen schwer zu vermeiden. Darüberhinaus gewährleistet die Verwendung einer einfachen Scheibe keine konstruktive Freizügigkeit in der Ausbildung dieser in der Benutzung oberen Schicht etwa zur Anpassung an spezielle Anwendungsfälle. Soweit die Umfangskontur der Scheibe von einer geraden Linie abweicht, ist erheblicher Aufwand für einen Zuschnitt der einzelnen Scheiben erforderlich, während die Form der Scheibe innerhalb der Umfangsränder von vorneherein festliegt.

Demgegenüber liegt der Erfindung die Aufgabe zugrunde, einen Solarzellengenerator der im Oberbegriff des Anspruchs 1 umrissenen Gattung zu schaffen, der eine einwandfreie Lagesicherung und vorbestimmte Lagedefinition der einzelnen Solarzellen sowie konstruktive Freizügigkeit hinsichtlich der Ausbildung der an der Vorderseite der Solarzellen liegenden Schicht ermöglicht.

Diese Aufgabe wird durch die kennzeichnenden Merkmale des Anspruchs 1 gelöst.

Durch die Ausbildung der ersten Schicht als Spritzgußteil bereitet es keine ins Gewicht fallenden Schwierigkeiten, dieses vorgefertigte Teil mit geeigneten Elementen zur Lagesicherung und Lagedefinition der einzelnen Solarzellen auszubilden, so daß ohne große Sorgfalt bei der Montage des Generators eine saubere definierte Lage der einzelnen Solarzellen sichergestellt ist. Darüberhinaus kann sowohl bezüglich der Umfangskontur der oberen, ersten Schicht und damit des ganzen Generators als auch hinsichtlich der Ausbildung wie etwa der Dickenverteilung im Inneren der ersten Schicht ohne Mehraufwand eine gewünschte Anpassung an die jeweiligen Erfordernisse erzielt werden. Insbesondere kann etwa die Umfangskontur dem Außenumfang der jeweils äußeren, in der Regel runden Solarzellen folgen und kann so eine material-
und insbesondere auch platzsparende Ausbildung des Generators erzielt werden. Im Inneren der ersten Schicht kann
diese mit variabler Dicke ausgeführt werden, sei es, um
in den Lücken zwischen den einzelnen Solarzellen Material
und damit auch Gewicht zu sparen, sei es, um die Lichteinfallsverhältnisse auf die Oberflächen der Solarzellen in
einer gewünschten Weise zu beeinflussen.

Die Ansprüche 2 bis 20 haben bevorzugte Weiterbildungen
des Solarzellengenerators zum Inhalt, während Anspruch 21
eine für eine spezielle Weiterbildung des erfindungsgemäßen Solarzellengenerators besonders geeignete Verwendung
betrifft.

In den Ansprüchen 22 bis 26 ist ein besonders geeignetes
Verfahren zur Herstellung eines erfindungsgemäßen Solarzellengenerators angegeben.

Die Erfindung wird nachfolgend anhand der Zeichnung näher
erläutert.
Es zeigt

Fig. 1    eine Unteransicht auf die als Spritzgußteil vorgefertigte obere, erste Schicht eines erfindungsgemäßen Solarzellengenerators,

Fig. 2    einen Schnitt gemäß Linie 2-2 in Fig. 1,

Fig. 3    einen fertigen Solarzellengenerator in einer Fig. 2
          entsprechenden Darstellung,

Fig. 4    eine Draufsicht auf einen Verbundgenerator aus einer
          Vielzahl von Solargeneratoren gemäß Fig. 1 bis 3,

Fig. 5    einen Schnitt durch den Verbundgenerator gemäß Linie V-V

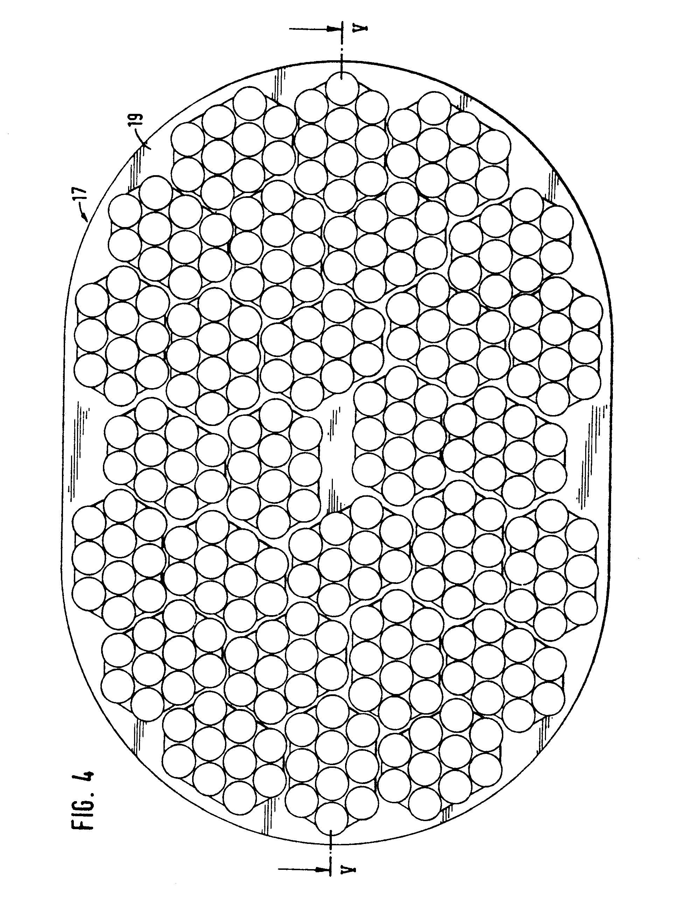

          in Fig. 4 und

Fig. 6    in vergrößerter Darstellung einen Teilschnitt des Verbundgenerators gemäß Fig. 5 zur Erläuterung der Herstellungsweise.

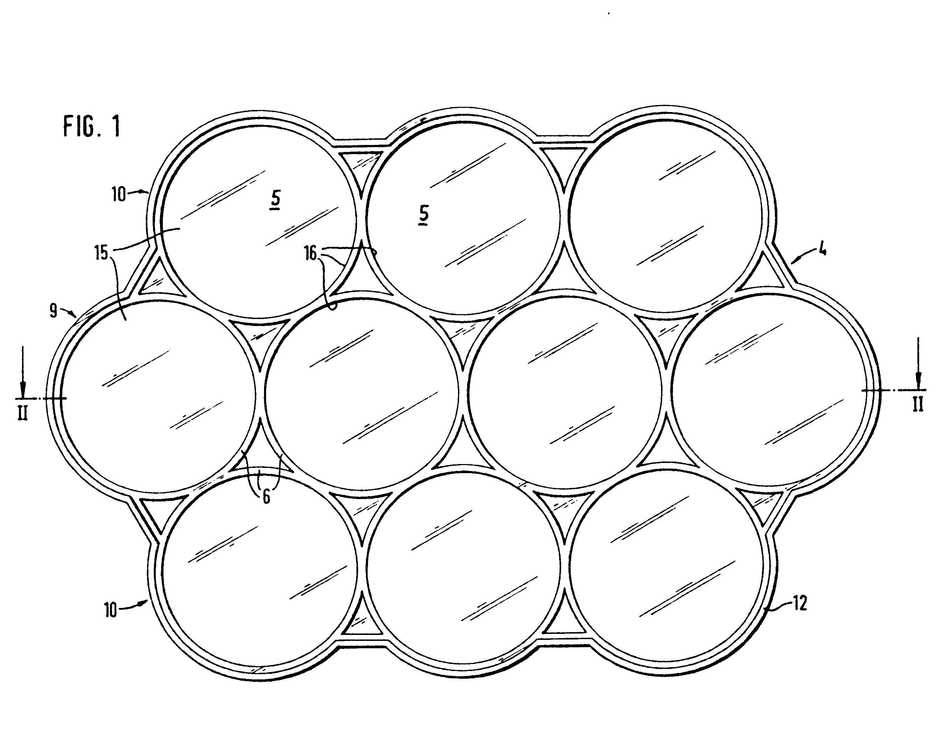

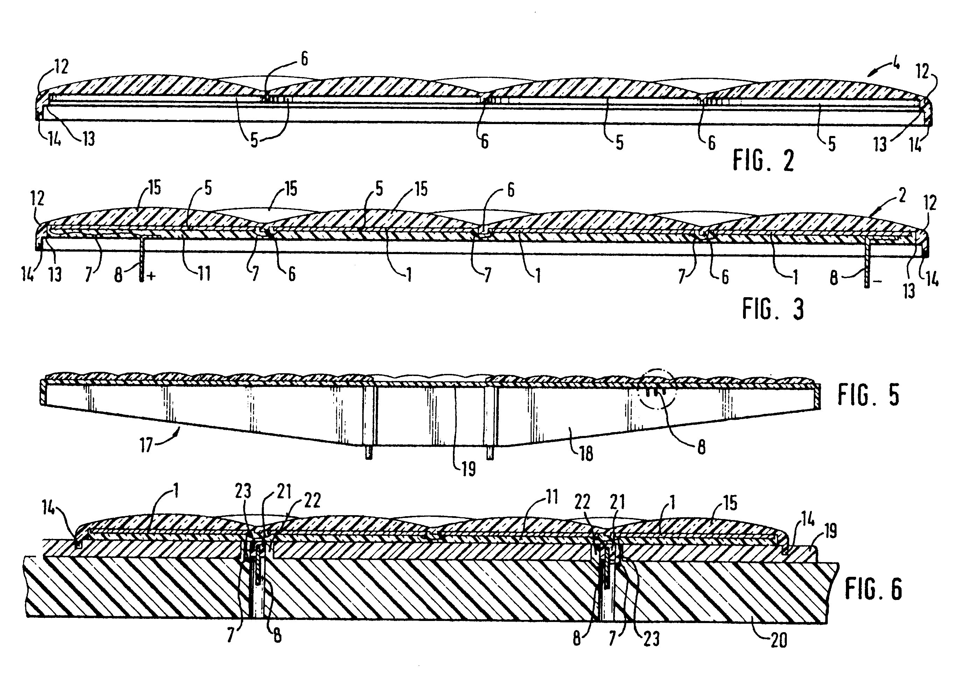

Der in den Fig. 1 bis 3 beispielhaft veranschaulichte Solarzellengenerator weist, wie insbesondere aus Fig. 3 ersichtlich ist, eine an der lichtempfindlichen Vorderseite der
einzelnen Solarzellen 1 angeordnete erste Schicht 2 sowie
eine an der Rückseite der Solarzellen 1 angeordnete zweite
Schicht 11 auf. Die obere, erste Schicht 2 ist als vorgefertigtes Spritzgußteil 4 ausgebildet, welches in den Fig. 1 und 2
einzeln dargestellt ist.

Das Spritzgußteil 4 besteht aus einem durchsichtigen Kunststoff auf Acrylbasis und weist an seiner zur Aufnahme der
Solarzellen 1 bestimmten Innenseite nestartige Vertiefungen 5
zur Aufnahme der einzelnen Solarzellen 1 auf. Zwischen den
Vertiefungen 5 sind Stege 6 vorgesehen, welche die Vertiefungen 5 umgeben und im wesentlichen der Kontur der im Beispielsfalle runden einzelnen Solarzellen 1 folgen. Auf diese Weise können die Solarzellen 1 in der insbesondere aus
Fig. 3 ersichtlichen Weise von der Rückseite des Spritzgußteiles 4 her in die nestartigen Vertiefungen 5 eingesetzt
werden, wo sie lagegesichert sind. Hierzu werden die einzelnen
Solarzellen 1 vorher bereits durch angelötete Verbindungsleitungen 7 miteinander in der gewünschten elektrischen
Schaltung verbunden und wird der schaltungstechnisch erste
und letzte Solargenerator je mit einer entsprechenden Kontaktfahne  8 verbunden, die im einen Fall direkt an die
leitende Rückseite des entsprechenden Solargenerators 1
angelötet sein kann, im anderen Fall über eine Verbindungsleitung 7 mit dem anderen Pol auf der Oberseite des entsprechenden Solargenerators 1 verbunden ist.

Im Beispielsfalle sind pro Solarzellengenerator zehn Solarzellen 1 vorgesehen, die, wie sich aus der Darstellung des
Spritzgußteiles in Fig. 1 ergibt, in einer Mittelreihe 9
mit vier nebeneinanderliegenden Solarzellen 1 und zwei daneben angeordneten Nebenreihen 10 mit je drei Solarzellen 1
angeordnet sind. Grundsätzlich können die Solarzellen 1 dabei in Parallelschaltung oder in Reihenschaltung miteinander
verbunden werden. Dabei kann im Falle einer Reihenschaltung
die eine Kontaktfahne 8 an der linken Solarzelle 1 der einen
Nebenreihe 10 angeschlossen werden, während die Solarzellen 1
der Nebenreihe 10 hintereinander geschaltet verbunden sind
und am jeweiligen Ende der Nebenreihen 10 eine Hintereinanderschaltung mit den jeweils benachbarten Solarzellen 1 der
Mittelreihe 9 erfolgt, so daß die zweite Kontaktfahne 8 an
der rechten Solarzelle der anderen Nebenreihe 10 am anderen
Pol vorgesehen wird. Insoferne sind die in Fig. 3 dargestellten Kontaktfahnen 8 in Wirklichkeit gegenüber der Zeichenebene nach hinten bzw. nach vorne versetzt, jedoch zur Verdeutlichung des Anschlusses so dargestellt, als seien sie
an den endseitigen Solarzellen der Mittelreihe 9 vorgesehen.
Im Falle einer solchen Reihenschaltung ergibt sich bei einer
üblichen Spannung von 0,55 Volt pro Zelle eine Spannung von
5,5 Volt je Einheit und eine Leistung von 3 Watt bei einer
Stromabgabe von 700 mA bei 4,5 V. Selbstverständlich kann
aber im Bedarfsfall auch eine Parallelschaltung von Solarzellen 1 erfolgen, wenn bei geringer Spannung die Stromstärke des Generators an den Kontaktfahnen erhöht werden
soll.

An der Rückseite des Spritzgußteiles 4 und der Solarzellen 1
ist die zweite Schicht 11 aus Kunststoff vorgesehen, in
welche auch die Verbindungsleitungen 7 sowie die Fußteile
der Kontaktfahnen 8 in der aus Fig. 3 ersichtlichen Weise
eingebettet sind, während die Anschlußbereiche der Kontaktfahnen 8 aus der zweiten Schicht 11 herausragen. Die zweite
Schicht 11 besteht aus einem Kunststoff auf Polyesterbasis,
der als Gußschicht auf die Rückseite des Spritzgußteiles 4
aufgebracht ist. Um bei der Herstellung eine Verwendung zusätzlicher Formteile für den Verguß der zweiten Schicht zu vermeiden, weist das vorgefertigte Spritzgußteil 4 an seinen Seitenrändern einen bis über die Dicke der zweiten Schicht 11 reichenden geschlossenen Umfangswulst 12 auf und bildet so selbst die Form für den Verguß der zweiten Schicht 11. Bei der Herstellung des Solarzellengenerators wird dabei so vorgegangen, daß zunächst das Aufbringen der zweiten Schicht 11 auf die Rückseite des Spritzgußteiles 4 in einer gegenüber den Fig. 2 und 3 umgedrehten Stellung erfolgt, wonach die elektrisch leitend miteinander verbundenen Solarzellen 1 durch die noch nicht feste Schicht 11 hindurch in die nestartigen Ausnehmungen 5 eingedrückt werden. Hierbei wird der noch flüssige Kunststoff der Schicht 11 an der Vorderseite der Solarzellen 1 verdrängt, so daß zwischen der lichtempfindlichen Vorderseite der Solarzellen 1 und dem der Kontur dieser Vorderseite angepaßten Boden, im Beispielsfalle also ebenfalls ebenen Boden der Ausnehmungen 5 eine blasenfreie dünne Schicht des Kunststoffes aus der zweiten Schicht 11 verbleibt. Bei geeigneter Abstimmung der Konsistenz und damit des Lichtbrechungsverhaltens der Kunststoffe der zweiten Schicht 11 und der ersten Schicht 2 bzw. des Spritzgußteiles 4 ergibt sich so eine im wesentlichen verlustfreie Beaufschlagung der lichtempfindlichen Vorderseiten der Solarzellen mit Licht, während bei einem nachträglichen Aufbringen der zweiten Schicht 11 nach dem Einlegen der Solarzellen 1 in die Vertiefungen 5 durch Luftblasen eine wesentliche Störung des gleichmäßigen Lichteinfalles zu befürchten ist.

Der Umfangswulst 12 ist in der aus den Fig. 2 und 3 ersichtlichen Weise hinter einer Schulter 13 an der Rückseite der zweiten Schicht 11 in einem Umfangsrand 14 weiter verlängert. Dadurch kann der Solarzellengenerator unmittelbar als abdichtender Deckel für einen nicht näher dargestellten, darunterliegenden Kasten zur Aufnahme von Speicher- und Regelaggregaten für den erzeugten Strom dienen, wobei der Umfangsrand 14 den entsprechend ausgebildeten Rand des Kastens
dichtend übergreift. Da der Umfangsrand 14 einstückig mit
dem Spritzgußteil 4 aus Kunststoff auf Acrylbasis ausgebildet ist, entsteht so gleichzeitig ein nach oben hin
dichter Abschluß des Kastens, der ein Eindringen von Regenwasser, Feuchtigkeit usw. gegebenenfalls unterstützt durch
zusätzliche Dichtelemente sicher verhindert.

Bei einer planen Ausbildung der Oberseite der ersten Schicht 2
ergibt sich bei schrägem Lichteinfall durch beispielsweise
niedrigen Sonnenstand eine geringe Licht- und damit Stromausbeute. Bei einer Verwendung solcher Aggragate beispielsweise zur Stromversorgung für die Positionslampen von Segelbooten od. dgl. ist es zur Aufladung der Speicheraggregate
für den erzeugten Strom daher erforderlich, je nach dem
Sonnenstand den Deckel mit den Solarzellen 1 aufzuklappen
und gegenüber der aufgehenden oder niedergehenden Sonne
auszurichten, um einen möglichst senkrechten Lichteinfall
auf die Vorderflächen der Solarzellen 1 zu erhalten. Abgesehen davon, daß dies beispielsweise bei kreuzenden Segelbooten eine dauernde neue Ausrichtung des Generators erfordert, ist dies auch in solchen Anwendungsfällen nachteilig, in denen normalerweise gar keine Bedienungsperson
zur Verfügung steht. Darüberhinaus führt ein Hochstellen
des Deckels ohne besondere, aufwendige Dichtmaßnahmen zu
einer Freilegung der Speicher- und Regelaggregate in den
darunter angeordneten Kasten, so daß diese Aggregate durch
Regenwasser, Spritzwasser usw. stark gefährdet sind.

Um diese Nachteile zu vermeiden, ist das Spritzgußteil 4
an seiner Oberseite mit variabler Dicke derart ausgebildet,
daß sich über den Solarzellen 1 konvexe Linsen 15 ergeben.
Die Linsen 15 sind entsprechend der Form der darunterliegenden Solarzellen 1 ebenfalls mit einem runden Umfangsrand 16
ausgebildet und übergreifen den Umfangsrand der darunterliegenden Solarzellen 1 um ein geringes Maß. Dadurch wird einerseits erreicht, daß bei senkrecht auftreffender Sonneneinstrahlung die Randzonen der Linsen das Licht in Richtung
auf die darunterliegenden Solarzellen ablenken, so daß auch
bei senkrecht auftreffender Sonneneinstrahlung eine gegenüber
der lichtempfindlichen Fläche der einzelnen Solarzellen 1
größere Beaufschlagungsfläche an Sonnenlicht erfaßt und auf
die Linse gelenkt wird, so daß sich hierdurch je nach der
Ausbildung der Linsen 15 im einzelnen ein mehr oder weniger
großer zusätzlicher Energiegewinn ergibt. Insbesondere aber
bei schrägem Lichteinfall wird andererseits eine höhere
Energieausbeute erzielt, da schräg einfallendes Licht durch
die Form der konvexen Linsen 15 in einem größeren Anteil
auf die Vorderfläche der Solarzellen 1 abgelenkt wird. Dadurch ist es ohne wesentlichen Energieverlust möglich, den
Solarzellengenerator in seiner Eigenschaft als Deckel ohne
Ausricht- oder Klappbewegungen in dichtender Anlage auf dem
Kasten zu belassen und dennoch eine ausreichende Energieausbeute zu erzielen. Daher eignet sich ein solcher Solarzellengenerator mit entsprechenden, darunter in einem Kasten
angeordneten Speicher- und Regelaggregaten etwa ganz besonders gut als Stromquelle für einen Weidezaun, da bei
jedem Lichteinfall ohne Änderung der Position eine ausreichende Energieausbeute erzielt wird und somit ein Dauerbetrieb ohne irgendeinen Eingriff einer Bedienungsperson
gewährleistet ist.

Eine besonders kompakte Ausbildung ergibt sich, wenn in der
aus Fig. 1 ersichtlichen Weise die Solarzellen 1 und damit
die Linsen 15 wabenartig auf Lücke mit geringstmöglichem
gegenseitigem Abstand angeordnet sind. Hierzu sind im Beispielsfalle die beiden Nebenreihen 10 gegenüber den Solarzellen 1 der Mittelreihe 9 auf Lücke versetzt angeordnet
und so nahe zusammengerückt, daß die Umfangsränder 16 der
Linsen 15 einander fast berühren. Damit wird auf geringstmöglichem Raum eine maximale Energieerzeugung sichergestellt. Die gedrängte Anordnung ebenso wie die durch die Verdickungen der einstückigen Linsen 15 herbeigeführte Aussteifung führen so zu einer formstabilen, bruchsicheren Ausführung des Solargenerators bei optimaler Material- und Platzausnutzung. Ohne Beeinträchtigung der Festigkeit kann daher die Dicke des Materials des Spritzgußteiles 2 im Bereich zwischen einander benachbarten Solarzellen 1 vermindert sein, zumal dort eine zusätzliche Aussteifung an der Unterseite des Spritzgußteiles 4 durch die Stege 6 erfolgt. Das Material des Spritzgußteiles 4 kann in der nach außen weisenden Lücke zwischen zwei benachbarten äußeren Solarzellen 1 bzw. Linsen 15 zurückgenommen werden, so daß die Außenkontur des Spritzgußteiles 4 eng der Außenkontur der Solarzellen 1 folgen kann.

Eine solche Ausbildung ermöglicht insbesondere auch eine platzsparende Bildung von Verbundgeneratoren aus einer Mehrzahl von Solarzellengeneratoren, wie dies in den Fig. 4 und 5 näher veranschaulicht ist. Dabei ist eine Konsole 17 mit einer ebenen Oberfläche und entsprechenden Versteifungsrippen 18 an der Unterseite als Träger für die Solarzellengeneratoren vorgesehen. Die Konsole 17 weist eine ebene Tragplatte 19 für die Solarzellengeneratoren auf, deren Dicke so bemessen ist, daß die Kontaktfahnen 8 an der Unterseite der Solarzellengeneratoren auf der der Tragseite abgewandten Rückseite der Tragplatte 19 herausragen können und dort durch eine geeignete Verkabelung in nicht näher dargestellter Weise miteinander verbunden werden können. In Fig. 5 sind in einem in einem strichpunktierten Kreis vorgesehenen Ausschnitt zur Verbesserung der Übersichtlichkeit lediglich einzelne der Kontaktfahnen 8 schematisch veranschaulicht.

Auch die Solarzellengeneratoren im Verbundgenerator können wahlweise in Reihen- oder Parallelschaltung geschaltet werden.

Im dargestellten Beispielsfall kann auf diese Weise eine
Leistung von etwa 80 Watt erzielt werden.

Dadurch, daß das Material am Umfang der Solarzellengeneratoren in den Lücken zwischen den äußeren Solarzellen 1 zurückgenommen ist, kann eine dicht gedrängte Anordnung der
Solarzellengeneratoren im Verbund in der veranschaulichten
Weise derart erfolgen, daß die Randauswölbungen im Bereich
der Solarzellen 1 benachbarter Generatoren in die Lücken
zwischen den Solarzellen 1 des angrenzenden Solarzellengenerators eingreifen. Auf diese Weise läßt sich auch bei
einem Verbundgenerator eine weitestgehende Ausnutzung der
Fläche erzielen, so daß ein großer Teil der erforderlichen
Baufläche durch die lichtempfindliche Fläche der Solarzellen 1 eingenommen wird, ohne daß ein einzelner Solarzellengenerator mit einer entsprechend großen Anzahl von
Solarzellen in aufwendiger weise gefertigt werden müßte.
Auf engstem Raum lassen sich so durch Zusammenschaltung
einzelner Solarzellengeneratoren die jeweils gewünschten
Leistungen nach dem Baukastenprinzip unter Verwendung der
stets gleichen, in Massenfertigung hergestellten Elemente
erzielen.

Die Konsole 17 und insbesondere ihre Tragplatte 19 bestehen
vorteilhaft aus Kunststoff und sind als Gußstück hergestellt.
Dabei können die einzelnen Solarzellengeneratoren vollständig vorgefertigt und mit ihrem Umfangsrand 14 an den
gewünschten Stellen in die freie Oberfläche des Konsolenrohlings vor dessen Aushärtung eingedrückt werden, wie dies
in Fig. 6 veranschaulicht ist. Auf einfachste Weise wird
dadurch eine sichere Verankerung der einzelnen Solarzellengeneratoren in der Tragplatte 19 gewährleistet.

Eine Schwierigkeit ergibt sich dadurch, daß die Kontaktfahnen bei der Vorfertigung der einzelnen Solarzellengeneratoren bereits an deren Rückseite vorgesehen sind und durch das
Material der Trägerplatte 19 hindurch gesteckt werden müssen,
so daß sie auf deren Rückseite frei zugänglich sind. Hierzu wäre denkbar, die in Fig. 6 mit 20 bezeichnete Formwand
für die Herstellung der Konsole 17 aus einem einstechbaren
Material auszubilden, so daß entsprechend stark ausgebildete
Kontaktfahnen an der Rückseite der noch nicht erstarrten
Trägerplatte 19 in das Material der Form 20 eindringen
können und nach Aushärtung der Konsole 17 wieder herausgezogen werden können. Jedoch ergeben sich hierdurch Unsicherheiten infolge möglicher Verbiegungen der Kontaktfahnen und von Verschmutzungen, die aufwendige Nacharbeiten
erforderlich machen könnten.

Daher wird in der aus Fig. 6 ersichtlichen Weise der Solarzellengenerator, und zwar vorzugsweise das Spritzgußteil 4
aus Acryl-Kunststoff mit Tragzapfen 21 für die Kontaktfahnen
ausgebildet. In diese Tragzapfen 21 werden die Kontaktfahnen,
die durch entsprechende Verbindungsleitungen 7 mit der zugehörigen Solarzelle 1 verbunden sind, nach der Einbettung
der Solarzellen 1 in die zweite Schicht 11 in die Stirnfläche der Tragzapfen 21 eingesteckt, wie dies in Fig. 6
veranschaulicht ist. Die Form 20 wiederum weist Kerne oder
ringartige Vorsprünge 22 auf, welche den Bereich der Tragzapfen 21 vom Material der Trägerplatte 19 freihalten. In
der inneren Seitenwand der Vorsprünge 22 sind Aussparungen 23
vorgesehen, durch welche hindurch die Verbindungsleitungen 7
zwischen der zugehörigen Solarzelle 1 und der Anschlußstelle
an der Kontaktfahne 8 außerhalb des Tragzapfens 21 verlaufen
können.

Auf diese Weise kann ein einzelner Solarzellengenerator derart auf die Form 20 mit dem noch nicht erstarrten Kunststoff
für die Trägerplatte 19 auf ihrer Oberseite eingesetzt werden, daß die Tragzapfen 21 in den Innenraum der ringförmigen
Vorsprünge 22 angreifen. Hierdurch ergibt sich zugleich
eine vorbestimmte Positionierung der einzelnen Solargeneratoren auf der Konsole 17, so daß eine vorbestimmte optimale gegenseitige Lage reproduzierbar erreicht werden kann,
ohne daß hierzu besondere Geschicklichkeit erforderlich ist.
Die Tragzapfen 21 ragen dabei so weit nach unten über die
Umfangsränder 14 des Spritzgußteiles 4 vor, daß ein bequemes Einstecken der Tragzapfen 21 in den Innenteil der
ringförmigen Vorsprünge 22 möglich ist, bevor der Umfangsrand 14 in den Kunststoff der Trägerplatte 19 eingedrückt
wird. Die Länge der Tragzapfen 21 kann dabei so gewählt
werden, daß, wie in Fig. 6 veranschaulicht ist, sich in
der fertigen Konsole ein bündiger Abschluß der Stirnflächen der Tragzapfen 21 mit der Unterseite der Trägerplatte 19 der Konsole 17 ergibt. Die Tragzapfen 21 sind zylindrisch, beispielsweise kreiszylindrisch ausgebildet
und können für eine saubere Führung der Form des Innenraumes der Vorsprünge 22 angepaßt sein.

W. Möbes Nachfl. GmbH & Co. KG
8351 Haus i.W. Nr. 117

Patentansprüche

1. Solarzellenanordnung zur Erzeugung elektrischer Energie mit einer vollständigen Kunststoffumhüllung einer Mehrzahl von nebeneinanderliegenden Solarzellen, die untereinander elektrisch leitend verbunden sind, wobei die Kunststoffumhüllung aus einer an der lichtempfindlichen Vorderseite der Solarzellen liegenden ersten Schicht und einer zweiten Schicht an der Rückseite der Solarzellen besteht, die als Gußschicht aufgebracht ist, dadurch gekennzeichnet, daß die erste Schicht (2) als Spritzgußteil (4) ausgebildet ist, das zur Aufnahme der Solarzellen (1) dient und eine diesem Zweck angepaßte Form aufweist.

2. Solarzellenanordnung nach Anspruch 1, dadurch gekennzeichnet, daß das Spritzgußteil (4) an seinen Seitenrändern einen bis über die Dicke der zweiten Schicht (11) reichenden geschlossenen Umfangswulst (12) aufweist.

3. Solarzellenanordnung nach Anspruch 1 oder 2, dadurch gekennzeichnet, daß das Spritzgußteil (4) an seiner Innenseite nestartige Vertiefungen (5) zur Aufnahme je einer Solarzelle (1) aufweist.

4. Solarzellenanordnung nach einem der Ansprüche 1 bis 3, dadurch gekennzeichnet, daß das Spritzgußteil (4) an seiner Außenseite über den einzelnen Solarzellen (1) vorzugsweise als einstückige Auswölbungen ausgebildete konvexe Linsen (15) aufweist.

5. Solarzellenanordnung nach Anspruch 4, dadurch gekennzeichnet, daß der Umfangsrand (16) der Linsen (15) dem Umfangsrand der darunterliegenden Solarzelle (1) folgt und diesen mit geringem Abstand übergreift, wobei vorzugsweise die Solarzellen (1) wabenartig mit geringstmöglichem gegenseitigem Abstand angeordnet sind.

6. Solarzellenanordnung nach Anspruch 5, dadurch gekennzeichnet, daß die Linsen (15) einen kreisförmigen Umfangsrand (16) aufweisen und einander mit diesem wenigstens annähernd berühren.

7. Solarzellenanordnung nach einer der Ansprüche 1 bis 6, dadurch gekennzeichnet, daß das Spritzgußteil (4) aus Kunststoff auf Acrylbasis besteht und daß die zweite Schicht (11) vorzugsweise aus einem Kunststoff auf Polyesterbasis besteht.

8. Solarzellenanordnung nach einem der Ansprüche 1 bis 7, dadurch gekennzeichnet, daß sie zehn Solarzellen (1) aufweist, wobei vorzugsweise vier Solarzellen (1) entlang einer geradlinigen Mittelreihe (9) angeordnet sind und je drei Solarzellen (1) zu jeder Seite der Mittelreihe um den halben Mittelpunktabstand der in der Mittelreihe (9) benachbarten Solarzellen (1) versetzt in Nebenreihen (10) angeordnet sind.

9. Solarzellenanordnung nach Anspruch 8, dadurch gekennzeichnet, daß die in einer Reihe (9 bzw. 10) benachbarten Solarzellen (1) untereinander in Reihe geschaltet sind, und daß die eine Nebenreihe (10) mit der Mittelreihe (9) und diese wiederum mit der anderen Nebenreihe (10) in Reihe geschaltet ist.

10. Solarzellenanordnung nach einem der Ansprüche 1 bis 9, dadurch gekennzeichnet, daß die Anschlüsse der Anordnung durch aus der Außenseite der zweiten Schicht (11) herausragende Kontaktfahnen (8) gebildet sind.

11. Solarzellenanordnung nach einem der Ansprüche 1 bis 10,
dadurch gekennzeichnet, daß sie als formstabiler, abdichtender Deckel für einen Kasten zur Aufnahme von Speicher-
und Regelaggregaten für den erzeugten Strom ausgebildet
ist.

12. Solarzellenanordnung nach einem der Ansprüche 1 bis 11, dadurch gekennzeichnet, daß das Material am Rand der Kunststoffumhüllung in zwischen benachbarten Solarzellen (1)
vorhandenen Lücken zurückgenommen ist.

13. Solargenerator mit einer Mehrzahl gleicher Solarzellenanordnungen nach Anspruch 12, die auf einer gemeinsamen, vorzugsweise aus einem Gußstück aus Kunststoff bestehenden Konsole aneinandergesetzt und elektrisch leitend miteinander
verbunden sind, dadurch gekennzeichnet, daß die zwischen
den Lücken gebildeten Vorsprünge einer Solarzellenanordnung in die Lücken benachbarter Solarzellenanordnungen eingreifen.

14. Solargenerator nach Anspruch 13, dadurch gekennzeichnet,
daß die Konsole (17) eine Trägerplatte (19) aufweist und
die Kontaktfahnen (8) durch die Trägerplatte (19) hindurchgreifen und an der Rückseite der Trägerplatte (19) frei
herausragen.

15. Verfahren zur Herstellung einer Solarzellenanordnung nach
wenigstens einem der Ansprüche 1 bis 12, wobei die erste
Schicht vorgefertigt wird und sodann die Solarzellen auf
die spätere Innenseite der ersten Schicht aufgelegt und
mit dem flüssigen Kunststoff der zweiten Schicht umgeben
werden, dadurch gekennzeichnet, daß zunächst der flüssige
Kunststoff für die zweite Schicht auf die Innenseite der
ersten Schicht aufgebracht und erst anschließend die elektrisch insbesondere durch Lötung miteinander vorab verbundenen Solarzellen in den noch nicht festen Kunststoff der zweiten Schicht eingedrückt werden.

16. Verfahren zur Herstellung eines Solargenerators nach Anspruch 14, dadurch gekennzeichnet, daß die Konsole in einer oben offenen Form aufrecht gegossen wird und daß die einzelnen Solarzellenanordnungen in die freie Oberfläche der Trägerplatte vor der Aushärtung der Konsole eingedrückt werden.

17. Verfahren nach Anspruch 16, dadurch gekennzeichnet, daß im Bereich der Kontaktfahnen an der Unterseite der Solarzellenanordnungen, vorzugsweise einstückig am Spritzgußteil, Tragzapfen angeformt werden, in welche die Kontaktfahnen eingesteckt werden, und daß an den Stellen der Tragzapfen in der Trägerplatte Aussparungen dadurch erzeugt werden, daß an der Form über die Höhe der Trägerplatte des Konsolenrohlings reichende ringartige Vorsprünge ausgebildet werden, in die die Tragzapfen mit den darin stekkenden Kontaktfahnen von oben her eingesetzt werden.

18. Verfahren nach Anspruch 17, dadurch gekennzeichnet, daß in der Innenwand der Vorsprünge eine Aussparung zur Aufnahme der Verbindungsleitung ausgebildet wird.

FIG. 1

FIG. 2

FIG. 3

FIG. 5

FIG. 6

FIG. 4

| Kategorie | Kennzeichnung des Dokuments mit Angabe, soweit erforderlich, der maßgeblichen Teile | betrifft Anspruch | KLASSIFIKATION DER ANMELDUNG (Int.Cl.²) |
|---|---|---|---|
| | **EINSCHLÄGIGE DOKUMENTE** | | |
| | GB - A - 1 023 847 (GENERAL ELECTRIC) <br><br> * Ansprüche; Figuren 1-3 * <br><br> -- | 1,4,6, 7,15 | H 01 L 31/02 25/04 |
| | US - A - 3 018 313 (D.H. GATTONE) <br><br> * Ansprüche; Figur 1 * <br><br> -- | 1,4 | |
| | US - A - 3 268 366 (PHILIPS) <br><br> * Spalte 2, Zeilen 4-54; Figuren 3,4 * <br><br> -- | 1 | **RECHERCHIERTE SACHGEBIETE (Int. Cl.²)** <br><br> H 01 L 31/02 25/04 |
| | FR - A - 2 349 959 (RTC) <br><br> * Seite 2, Zeilen 35-39; Seite 3, Zeilen 1-15; Seite 4, Zeilen 12-33; Figuren 1,2 * <br><br> -- | 1 | |
| P | US - A - 4 097 308 (TIDELAND SIGNAL CORP.) <br><br> * Spalte 2, Zeilen 60-68; Spalte 3, Zeilen 1-54; Figuren 1,3,4 * <br><br> ---- | 1,3 | |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 23-03-1979 | HASLAUER |

EPA form 1503.1 06.78